Europäisches Patentamt

European Patent Office

Office européen des brevets

(11) Publication number: **0 143 530**
**A1**

# (12) EUROPEAN PATENT APPLICATION

(21) Application number: 84306616.8

(22) Date of filing: 28.09.84

(51) Int. Cl.⁴: **H 01 B 1/22,** H 05 K 3/12,
C 09 D 5/24, B 05 D 5/12

(30) Priority: 30.09.83 US 537735

(71) Applicant: **ELECTRO MATERIALS CORP. OF AMERICA,**
**605 Center Avenue, Mamaroneck New York 10543 (US)**

(72) Inventor: **Martin, Frank Wayne, P O Box 243, Baldwin**
**Place New York 10505 (US)**
Inventor: **Shahbazi, Samson, 68 Highland Avenue,**
**Yonkers New York 10705 (US)**
Inventor: **Schoonejongen, Ronald James, R.D. 7, Craft**
**Road, Carmel New York (US)**

(43) Date of publication of application: 05.06.85
Bulletin 85/23

(74) Representative: **Angell, David Whilton, Rohm and Haas**
**Company Patent Department Chesterfield House**
**Bloomsbury Way, London WC1A 2TP (GB)**

(84) Designated Contracting States: **AT BE CH DE FR GB IT**
**LI LU NL SE**

(54) **A method for forming an electrically conductive polymer film containing silver and the electrically conductive silver/polymer composition itself.**

(57) A solderable electrically conductive composition comprises metallic silver particles embedded in a matrix formed from acrylic, carboxylated vinyl and epoxy resins and can be formed by dissolving acrylic powder and vinyl powder in respective solvents to form a first solution and a second solution, mixing these solutions with metallic silver particles and an epoxy to form an ink which is applied to a substrate to form a film thereon. The film is heated to evaporate the solvents, and preferably to allow polymerization to occur, thereby leaving the solderable electrically conductive film on the substrate.

EP 0 143 530 A1

A METHOD FOR FORMING AN ELECTRICALLY CONDUCTIVE POLYMER FILM
CONTAINING SILVER AND THE ELECTRICALLY CONDUCTIVE
SILVER/POLYMER COMPOSITION ITSELF.

The invention relates to a method for forming an electrically conductive polymer film containing silver and the electrically conductive silver/polymer composition itself.  The invention provides solderable silver/polymer films.

Conductive polymer films are well known, and used in connection with printed circuits to connect the elements of the circuits and to provide an electrical connection to other circuits.  Most of these conductive polymer films contain noble metals such as silver or gold to render them conductive.

Typically, the films are applied to a substrate, such as a circuit board, by silk screening methods and then cured.  Present conductive polymer films will not accept solder and require the application of a plated metal surface which is solderable.  The plated metal surface may be applied by either electroless or electroplate techniques. Electrical connections may then be made to the conductive film by soldering the electrical leads to the plated metal surface.  Soldering must be performed very carefully as the conductive polymer films containing silver are subject to leaching, which is the dissolving of the silver into the solder during soldering, often resulting in the removal of the conductive silver from the substrate and rendering the substrate unusable.

The plating of presently available conductive polymer films is required to render them solderable.  The plating currently applied to most conductive polymer films is an electroless bath of either nickel boron or nickel phosphorus.  Plating, however, is inconvenient on a small scale and presents major problems where substantial production of plated conductive polymer films (such as in printed circuit boards) is contemplated. For example,
electroless nickel plating of conductive polymer films on a
volume production basis requires the establishment of a
suitable plating facility which is a large, expensive and
complicated venture. Specifically, the plating room must
have a suitable quantity and quality of ventilation and the
various levels of air flow must be controlled. The tanks
used for plating should be formed from fiberglass,
polypropylene, polyethylene or other suitable high
temperature resistant (200°F range) material. The tanks
must also be capable of withstanding nitric acid cleaning on
a periodic basis. In addition, a holding tank and a
transfer system is required to empty and refill the plating
tank when nickel salts reach a certain concentration
requiring that the tank be purged. Low watt density
immersion heaters made of quartz or passivated stainless
steel are necessary to provide the appropriate level of
heat. The use of immersion heaters require agitation by
forced air impinging directly on the heaters to avoid
localized heating. Jacketed tanks may be used in place of
the immersion heaters but vigorous agitation is required in
any case. The use of non-metallic or other acid resistant
products is recommended. Continuous filtration of the
plating bath must be performed each day. A polypropylene
cartridge filter is recommended, which filter should be
purged with hot water and the cartridge filter changed 6 to
10 times per hour for continuous filtration. Of course, the
continuous filtration requires a pump suitable for
continuous operation at 200°F.

It will readily be appreciated that a solderable
conductive film would eliminate the need for the entire
plating operation described above and is therefore highly
desirable. In addition, a solderable conductive film in
which the conductive particles are resistent to leaching
would also be desirable.

Accordingly, one object of the present invention is to provide an electrically conductive film which is solderable.

Another object of the present invention is to provide an electrically conductive film which is solderable without the application of a plated metal surface or any other subsequent coating operation.

Still another object of the present invention is to provide an electrically conductive film which is solderable by any standard soldering technique.

A further object of the present invention is to provide a solderable electrically conductive film in which the conductive particles will not leach off the substrate during normal soldering.

A still further object of the present invention is to provide a solderable film which is highly electrically conductive.

In accordance with the present invention, a solderable electrically conductive composition includes metallic silver particles embedded in a matrix formed from acrylic, carboxylated vinyl and epoxy. The composition may be formed by dissolving vinyl powder and acrylic powder in respective solvents to form first and second solutions. The solutions can then be mixed with metallic silver particles and epoxy to form an ink, which is applied to a substrate to form a film thereon. The film is dried by evaporating the solvents, and preferably cured to allow polymerization to occur, thereby leaving a solderable electrically conductive film, formed from metallic silver particles embedded in a matrix containing acrylic, vinyl and epoxy, on the substrate.

The solderable electrically conductive composition of the present invention is made up of metallic silver particles embedded in a matrix containing acrylic, carboxylated vinyl and a moderate chain-length epoxy. The composition can be formed by dissolving a suitable acrylic powder such as Acryloid B66, a product of the Rohm and Haas Company, which is a methyl/butyl methacrylate copolymer, in a solvent such as butyl carbitol acetate to form a liquid acrylic resin. A liquid vinyl resin is formed by dissolving carboxylated vinyl powder in a solvent, such as butyl carbitol acetate. The acrylic resin and vinyl resin are then mixed together with the silver particles and the epoxy to form an ink. The silver particles may be either in a granular powder or flake form with a typical particle size of 1 to 10 microns. Any suitable moderate chain length epoxy may be used such as the epoxy sold under the trademark 828 by Shell, the epoxy sold under the trademark Lonco PC No. 549 Solder Resist by London Chemical Co. or the epoxy sold under the trademark 9440 Solder Resist by MacDermid Inc.

Each of the materials is usually weighed in a clean stainless steel bowl. The vinyl and acrylic are then dissolved in solvents to form the acrylic resin and vinyl resin solutions. The silver particles, epoxy and vinyl and acrylic resins are then blended with a mixer until the silver powder is dispersed, thereby forming an ink. The silver powder preferably makes up from 68 to 75% by weight of the ink with a more preferred amount being about 70%. The acrylic resin solution preferably makes up from 14 to 20% by weight of the ink with a more preferred amount being 16%. The ratio of acrylic powder to solvent in the resin is 40% acrylic to 60% solvent. The vinyl resin should make up from 12 to 15% by weight of the ink with a preferred amount being 12%. The ratio of vinyl powder to solvent in the resin is 50% vinyl to 50% solvent. The epoxy should make up from 1.5 to 2.5% by weight of the ink with a preferred amount being 2%.

The ink is then milled using a 3-roll mill until the desired fineness of grind is achieved. This may require 3 to 6 passes through the 3-roll mill. A fineness of grind of 7 microns or less is desirable.

The viscosity of the ink may be lowered if necessary with the addition of more solvent in 0.5% by weight increments. A viscosity of 50 to 80 $Ns/m^2$ (50,000 to 90,000 cps) is desired for most applications. The ink may then be applied to any substrate capable of withstanding the curing temperature of the ink. Typical substrates include those formed from epoxy and fiberglass. For example, the ink may be screen printed onto conventional circuit boards to connect one element of a circuit to another or to provide an electrical connection to another circuit. For this application the ink may be screen printed using conventional silk screening methods to form lines of conductive film as narrow as 10 mils in width and with a spacing of as little as 10 mils from other lines. The ink may also be applied to the leads of surface mounted devices such as capacitors, light emitting diodes, solar cells, dual in-line package integrated circuits and small outline integrated circuit packages. For this application the leads of the surface mounted devices may be dipped in the ink or the ink may be sprayed onto the leads. The ink may also be used to provide the leads for leadless surface mounted devices.

The ink forms a film on the substrate which is then dried and cured. The film is cured by exposing the substrate to an ambient temperature between 150 to 170°C for 40 to 50 minutes. This may be done by placing the substrate in a convection oven, having a nitrogen or oxygen atmosphere.

During drying and curing, solvent is evaporated and polymerization occurs, leaving a hard, solderable, electrically conductive film formed from metallic silver particles embedded in a matrix formed from acrylic, carboxylated vinyl and epoxy. The film adheres well to the substrate, requiring more than 8.9 N (2 pounds of force) to remove it therefrom.

It will readily be appreciated that the metal content of the cured film is greater than the metal content of the ink as the solvent evaporates during curing. The metallic silver particles preferably make up from 82 to 88% by weight of the cured film with a more preferred amount being about 82%. The acrylic preferably makes up from 6 to 9% by weight of the cured film with a more preferred amount being about 7%. The carboxylated vinyl preferably makes up from 7 to 9% by weight of the cured film with a more preferred amount being about 7%. The epoxy preferably makes up from 1.7 to 3% by weight of the cured film with a more preferred amount being about 2%. The cured film retains its adhesion properties and cohesive strength. It is believed that the epoxy gives the film good adhesive properties to ensure that the film sticks to the substrate to which it is applied. In addition, the epoxy makes the silver particles of the film slightly solder resistant thereby preventing the leaching (dissolving into the solder) of the silver particles during soldering.

In a specific embodiment prepared according to the preferred parameters described above, the cured film provides good electrical conductivity having a resistivity of .2 ohms per square per 0.254 mm (1 mil) thick. Any size square of the cured film having a thickness of 0.0254 mm (1 mil) will have a resistivity of .2 ohms. In addition, the film exhibits solderability in that the solder adheres directly to the film and as a result no plating or any subsquent coating operation is necessary. Solder may be applied by use of a soldering iron or any standard soldering technique. No special flux is required and standard activated rosin flux may be used. In addition, the cured film may be soldered by a solder dip process without creating a solder leach problem. For example, the cured film may be dipped for 5 seconds into a solder bath having a temperature of 200°C without the solder dissolving the silver particles off the substrate.

CLAIMS:

1.     A method for forming a solderable electrically conductive film comprising the steps of forming an ink comprising (a) acrylic and carboxylated vinyl polymers dissolved in solvent, (b) metallic silver particles and (c) epoxy resin, applying said ink to a substrate to form a film thereon, and drying the film by heating to leave a solderable electrically conductive film on the substrate.

2.     A method as claimed in Claim 1 which the ink contains the following components in the specified weight ratios 82 to 88 silver:6 to 9 acrylic polymer:7 to 9 carboxylated vinyl:1.7 to 3 epoxy resin.

3.     A method as claimed in any preceding claim in which the film is cured at a temperature of 150 to 170°C for 40 to 50 minutes.

4.     A method as claimed in any preceding claim in which the substrate is a circuit board.

5.     A method as claimed in Claim 4 in which the ink is applied to the circuit board by screen printing.

6.     A method as claimed in any preceding claim in which said epoxy comprises moderate chain length epoxy.

7.     A method as claimed in any preceding claim in which the solvent comprises butyl carbitol acetate.

8.     A method as claimed in any preceding claim which comprises forming separate solutions of the acrylic and carboxylated vinyl polymers and mixing them together with the metallic silver particles and the epoxy resin.

9.      A solderable electrically conductive composition
comprising metallic silver particles embedded in a matrix
formed from acrylic, carboxylated vinyl and epoxy resins.

0143530

European Patent Office

**EUROPEAN SEARCH REPORT**

. Application number

EP 84 30 6616 .

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | DE-A-2 938 465 (PREH ELEKTROFEIN MECHANISCHE WERKE J.PREH NACHF. GmbH) ----- | | H 01 B 1/22<br>H 05 K 3/12<br>C 09 D 5/24<br>B 05 D 5/12 |

TECHNICAL FIELDS SEARCHED (Int. Cl.4)

B 05 D
C 09 D
H 01 B
H 05 K

The present search report has been drawn up for all claims

| Place of search | Date of completion of the search | Examiner |
|---|---|---|
| THE HAGUE | 16-01-1985 | VAN THIELEN J.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date .
D : document cited in the application
L : document cited for other reasons

& : member of the same patent family, corresponding document

EPO Form 1503 03 82